# EUROPEAN PATENT SPECIFICATION

(11) **EP 4 376 210 B1**
(45) Date of publication and mention of the grant of the patent: **30.09.2026**
(21) Application number: 23848775.5
(22) Date of filing: 08.08.2023
(51) Int. Cl.: H01M 50/569, H01M 50/178, H01M 50/548, H01M 50/184, H01M 50/186, H01M 10/48, H01M 50/119, H01M 50/129, H01M 50/183, H01M 50/174, H01M 50/105, H01M 50/126, H01M 50/211, H01M 10/42

(54) **POUCH-TYPE BATTERY CELL AND BATTERY MODULE INCLUDING SAME**
BEUTELARTIGE BATTERIEZELLE UND BATTERIEMODUL DAMIT
ÉLÉMENT DE BATTERIE DE TYPE POCHE ET MODULE DE BATTERIE LE COMPRENANT

(30) Priority: 08.09.2022 KR 20220113970
(43) Date of publication of application: 29.05.2024
(73) Proprietor: LG ENERGY SOLUTION, LTD., Seoul 07335 (KR)
(72) Inventor: BAEK, Doo Hyun, Daejeon 34122 (KR); CHO, Seung Su, Daejeon 34122 (KR); BAEK, Sang Min, Daejeon 34122 (KR); YI, Young Mi, Daejeon 34122 (KR)
(74) Representative: Plasseraud IP
(86) International application number: PCT/KR2023/011663
(87) International publication number: WO 2024/053878

(56) References cited:
- EP-A1- 3 972 035
- CN-A- 110 441 356
- CN-A- 112 242 572
- CN-U- 207 096 415
- JP-A- 2012 028 023
- KR-A- 20160 128 835
- KR-A- 20220 046 135
- KR-B1- 101 433 195
- KR-B1- 101 487 496

## Description

### [Technical Field]

The present invention relates to a pouch-shaped battery cell and a battery module including the same, and more particularly to a pouch-shaped battery cell capable of determining in real time whether a battery cell is defective and preventing or delaying gas venting and a battery module including the same.

### [Background Art]

With the recent development of alternative energies, spurred by the use of fossil fuels which cause air pollution and energy depletion, demand for secondary batteries capable of storing electrical energy has increased. Secondary batteries, which are capable of being charged and discharged, are intimately used in daily life. For example, secondary batteries are used in mobile devices, electric vehicles, and hybrid electric vehicles.

An increase in usage and complexity of mobile devices, as well as the development of electric vehicles, has increased the required capacities of lithium secondary batteries used as energy sources of various kinds of electronic devices inevitably used in modern society. In order to satisfy demand of users, a plurality of battery cells is disposed in a small-sized device, whereas a battery module including a plurality of battery cells electrically connected to each other or a battery pack including a plurality of battery modules is used in a vehicle, etc.

Meanwhile, in a pouch-shaped battery cell, a lower case and an upper case are manufactured using a laminate sheet including an inner resin layer, a metal layer, and an outer resin layer, and the lower case and the upper case are joined to each other by thermal fusion in the state in which the lower case and the upper case face each other.

However, the lower case and the upper case are more susceptible to damage than a cylindrical case or a prismatic case, and if damage occurs and the metal layer is exposed, moisture may permeate, short circuit may occur, or electrical insulation may be deteriorated due to corrosion of the metal layer, which may lead to fire.

In addition, gas generated during repeated charging and discharging processes or events is one of the factors that threaten safety of the battery cell.

### (Prior Art Document)

(Patent Document 1) Korean Patent Application Publication No. 2014-0032710 (published on March 17, 2014)

Documents KR 101 433 195 B1, EP 3 972 035 A1, CN 110 441 356 A and KR 101 487 496 B1 relate to the measurement of the quality and integrity of the pouch film in pouch-shaped battery cells.

### [Disclosure]

### [Technical Problem]

The present invention has been made in view of the above problems, and it is an object of the present invention to provide a pouch-shaped battery cell capable of determining whether the pouch-shaped battery cell is normal and a battery module including the same.

It is another object of the present invention to provide a pouch-shaped battery cell capable of preventing or delaying gas venting and a battery module including the same.

### [Technical Solution]

To this end, the invention relates to a pouch-shaped battery cell according to claim 1.

The pouch-shaped battery cell after the invention may present one or more feature(s) of dependent claims 2 and 3, in any combination allowed by the claims.

The invention also relates to a battery module according to claims 4 to 6 and to a battery pack according to claim 7.

### [Advantageous Effects]

As is apparent from the above description, in a pouch-shaped battery cell according to the present invention and a battery module including the same, an auxiliary terminal in contact with a metal layer of a pouch case is mounted to a sealed portion, whereby it is possible to measure and monitor insulation resistance or insulation voltage of the battery cell in real time, and therefore it is possible to contribute to securing the safety of the battery cell.

Also, in the pouch-shaped battery cell according to the present invention and the battery module including the same, the auxiliary terminal is fixed so as to enclose the sealed portion, whereby it is possible to prevent or delay gas venting, and therefore it is possible to extend the lifespan of the battery cell.

### [Description of Drawings]

FIG. 1 is an exploded perspective view of a pouch-shaped battery cell provided with an auxiliary terminal according to an example that is not part of the invention.
FIG. 2 is a perspective view of the pouch-shaped battery cell shown in FIG. 1.
FIG. 3 is a view illustrating a process of mounting the auxiliary terminal in the pouch-shaped battery cell shown in FIG. 2.
FIG. 4 is a view illustrating a process of mounting an auxiliary terminal according to a preferred second embodiment of the present invention.
FIG. 5 is a view illustrating a process of mounting an auxiliary terminal according to a preferred third embodiment of the present invention.
FIG. 6 is a perspective view of a pouch-shaped battery cell according to another example that is not part of the invention.
FIG. 7 is a perspective view of a pouch-shaped battery cell according to an embodiment of the present invention.
FIG. 8 is a schematic view showing a battery module according to another example that is not part of the invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the entire specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a pouch-shaped battery cell according to the present invention and a battery module including the same will be described with reference to the accompanying drawings.

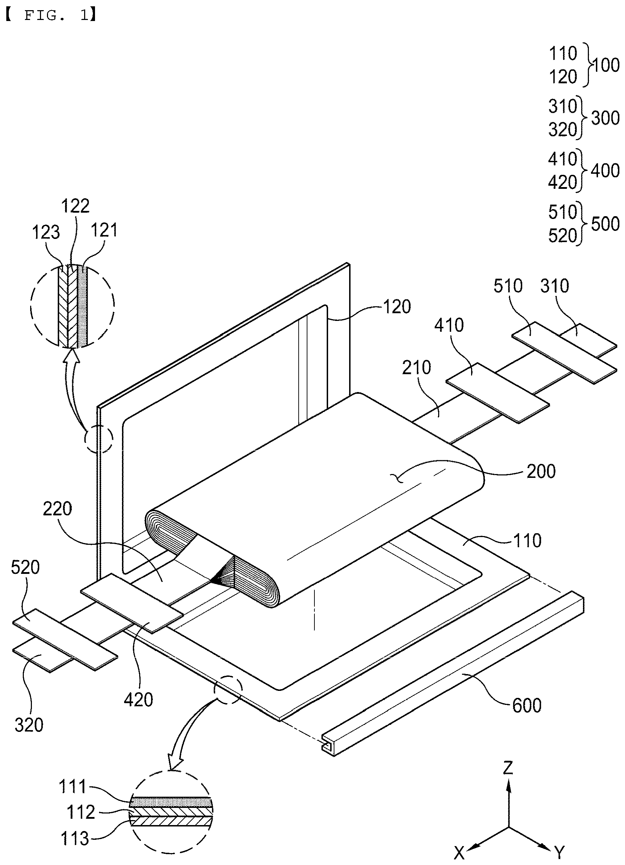

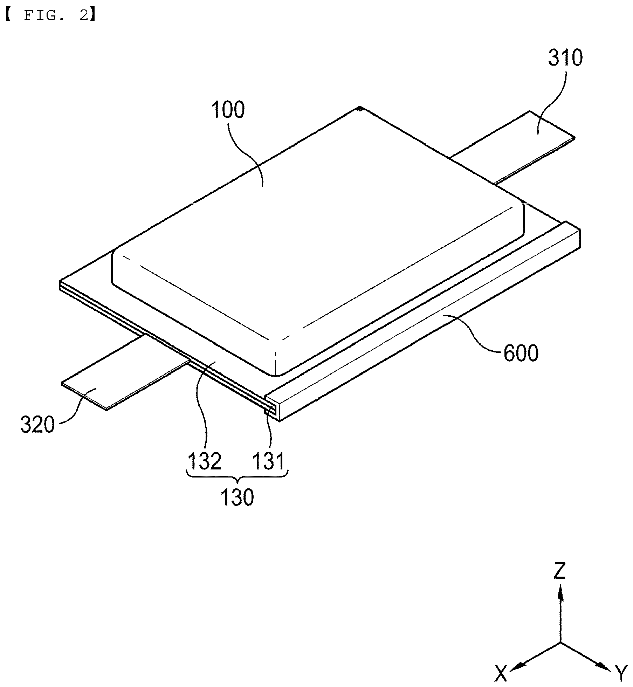

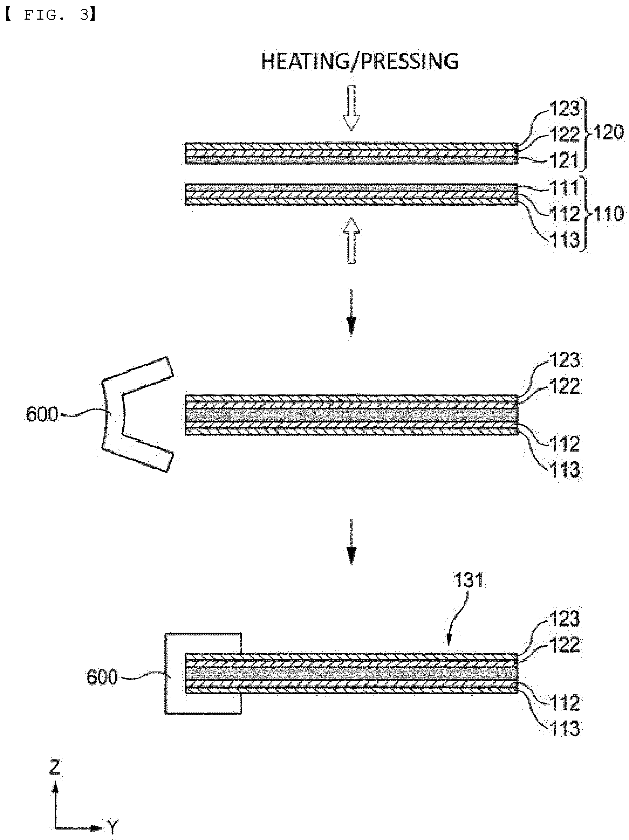

FIG. 1 is an exploded perspective view of a pouch-shaped battery cell provided with an auxiliary terminal according to an example that is not part of the invention, FIG. 2 is a perspective view of the pouch-shaped battery cell shown in FIG. 1, and FIG. 3 is a view illustrating a process of mounting the auxiliary terminal in the pouch-shaped battery cell shown in FIG. 2.

As shown in FIGs. 1 to 3, the pouch-shaped battery cell according to the present invention includes a pouch case 100, an electrode assembly 200, an electrode lead 300, a protective tape 400, a lead film 500, and an auxiliary terminal 600.

First, the pouch case 100 may be constituted by a lower case 110 and an upper case 120, and a pocket-shaped receiving space configured to receive the electrode assembly 200 is formed in the pouch case.

The pouch case 100 is made of a laminate sheet including an outer resin layer, a metal layer, and an inner resin layer in order to form a receiving portion therein.

Specifically, the lower case 110 may include a first inner resin layer 111 located at the innermost side, a first metal layer 112 located in the middle, and a first outer resin layer 113 located at the outermost side.

Even in the case of the upper case 120, a second inner resin layer 121 is located at the innermost side, a second metal layer 122 is located in the middle, and a second outer resin layer 123 is located at the outermost side.

Each of the first outer resin layer 113 and the second outer resin layer 123, which are located at the outer sides of the pouch case 100, may be made of a heat-resistant polymer that exhibits excellent tensile strength, resistance to moisture permeation, and resistance to air transmission in order to secure heat resistance and chemical resistance while protecting the electrode assembly 200. As an example, the outer resin layer may be made of nylon or polyethylene terephthalate; however, the present invention is not limited thereto.

The metal layers, which are disposed so as to abut the outer resin layers, i.e., the first metal layer 112 and the second metal layer 122, each of which is located in the middle of the pouch case 100, correspond to barrier layers configured to prevent moisture or various kinds of gas from permeating into the battery. An aluminum thin film, which is lightweight and easily shapeable, may be used as a preferred material for each of the metal layers.

The first inner resin layer 111 and the second inner resin layer 121, each of which is located at the innermost side of the pouch case 100, are disposed in direct contact with the electrode assembly 200, and therefore each of the inner resin layers must exhibit high insulation properties and high resistance to an electrolytic solution. In addition, each of the inner resin layers must exhibit high sealability in order to hermetically seal the pouch case from the outside, i.e., a thermally-bonded sealed portion between the inner resin layers must exhibit excellent thermal bonding strength.

Each of the first inner resin layer 111 and the second inner resin layer 121 may be made of a material selected from among a polyolefin-based resin, such as polypropylene, polyethylene, polyethylene acrylate, or polybutylene, a polyurethane resin, and a polyimide resin, which exhibit excellent chemical resistance and high sealability. However, the present invention is not limited thereto, and polypropylene, which exhibits excellent mechanical properties, such as tensile strength, rigidity, surface hardness, and impact resistance, and excellent chemical resistance, is the most preferably used.

Although the receiving space is shown as being provided in each of the upper case 120 and the lower case 110 in FIGs. 1 and 2, it is obvious that the receiving space is provided in any one of the upper case 120 and the lower case 110.

Next, the electrode assembly 200 will be described. The electrode assembly 200, which is seated in the receiving space of the pouch case 100, may be a jelly-roll type electrode assembly, which is configured to have a structure in which a long sheet type negative electrode and a long sheet type positive electrode are wound in the state in which a separator is interposed therebetween, a stacked type electrode assembly including unit cells, each of which is configured to have a structure in which a rectangular positive electrode and a rectangular negative electrode are stacked in the state in which a separator is interposed therebetween, a stacked and folded type electrode assembly, which is configured to have a structure in which unit cells are wound using a long separation film, or a laminated and stacked type electrode assembly, which is configured to have a structure in which unit cells are stacked in the state in which a separator is interposed therebetween and are then attached to each other; however, the present invention is not limited thereto.

Specifically, the negative electrode is manufactured by applying a slurry mixture of a negative electrode active material and a binder to a negative electrode current collector.

As the negative electrode active material, for example, there may be used carbon, such as non-graphitizing carbon or graphite-based carbon; a metal composite oxide, such as LiₓFe₂O₃ (0≤x≤1), LiₓWO₂ (0≤x≤1), SnₓMe₁₋ₓMe'_{y}O_{z} (Me: Mn, Fe, Pb, Ge; Me': Al, B, P, Si, Group 1, 2, and 3 elements of the periodic table, halogen; 0<x≤1; 1≤y≤3; 1≤z≤8); a lithium metal; a lithium alloy; a silicon-based alloy; a tinbased alloy; a metal oxide, such as SnO, SnO₂, PbO, PbO₂, Pb₂O₃, Pb₃O₄, Sb₂O₃, Sb₂O₄, Sb₂O₅, GeO, GeO₂, Bi₂O₃, Bi₂O₄, or Bi₂O₅; a conductive polymer, such as polyacetylene; a Li-Co-Ni-based material; or a Si-based material, such as Si, SiO, SiO₂, or a mixture thereof; however, the present invention is not limited thereto.

The positive electrode is manufactured by applying a slurry mixture of a positive electrode active material and a binder to a positive electrode current collector.

The positive electrode active material may be constituted, for example, by a layered compound, such as a lithium cobalt oxide (LiCoO₂) or a lithium nickel oxide (LiNiO₂), or a compound substituted with one or more transition metals; a lithium manganese oxide represented by the chemical formula Li₁₊ₓMn₂₋ₓO₄ (where x = 0 to 0.33) or a lithium manganese oxide, such as LiMnO₃, LiMn₂O₃, or LiMnO₂; a lithium copper oxide (Li₂CuO₂); a vanadium oxide, such as LiV₃O₈, V₂O₅, or Cu₂V₂O₇; a Ni-sited lithium nickel oxide represented by the chemical formula LiNi₁₋ₓMₓO₂ (where M = Co, Mn, Al, Cu, Fe, Mg, B, or Ga, and x = 0.01 to 0.3); a lithium manganese composite oxide represented by the chemical formula LiMn₂₋ₓMₓO₂ (where M = Co, Ni, Fe, Cr, Zn, or Ta, and x = 0.01 to 0.1) or the chemical formula Li₂Mn₃MO₈ (where M = Fe, Co, Ni, Cu, or Zn); LiMn₂O₄ in which a part of Li in the chemical formula is replaced by alkaline earth metal ions; a disulfide compound; or Fe₂(MoO₄)₃; however, the present invention is not limited thereto.

Meanwhile, each of the negative electrode current collector and the positive electrode current collector is constituted by a portion to which the slurry including the active material is applied and an uncoated portion to which no slurry is applied. The uncoated portion is cut, or a separate conductive member is connected to the uncoated portion by ultrasonic welding, to form a pair of electrode tabs, i.e., a positive electrode tab 210 and a negative electrode tab 220.

A positive electrode lead 310 and a negative electrode lead 320, which constitute a pair of electrode leads 300, are electrically connected to the positive electrode tab 210 and the negative electrode tab 220, respectively, and are exposed to the outside of pouch case 100.

Here, the pair of electrode tabs and the pair of electrode leads 300 may be electrically connected to each other by welding, more specifically ultrasonic welding. Coupling by ultrasonic welding is performed according to the principle by which high-frequency vibration generated by an ultrasonic wave of about 20 kHz is applied and vibration energy is converted into thermal energy due to friction at the interface between the electrode tab and the electrode lead as the result of operation of a horn and an anvil, whereby welding is rapidly performed.

Next, the protective tape 400 will be described. The protective tape 400 is disposed so as to enclose the part at which the electrode tab and the electrode lead 300 overlap each other, i.e., a weld thereof.

Since the electrode tab and the electrode lead 300 are connected by welding, surfaces of the electrode tab and the electrode lead 300 may not be smooth, which leads to poor insulation.

Specifically, if the surface of the weld is not smooth, when the weld and the pouch case 100 come into contact with each other due to impact, the inner resin layer is peeled off, whereby the metal layer is exposed, resulting in poor insulation. Consequently, it is preferable to enclose the weld using the protective tape 400 in order to prevent poor insulation.

Here, the protective tape 400 may be made of an insulative material. As an example, the protective tape may be made of polypropylene, polyethylene, polyester, or polyimide. However, the present invention is not limited thereto as long as the material is capable of enclosing the weld and remaining insulated when in contact with the pouch case 100.

The lead film 500, which is constituted by a first lead film 510 and a second lead film 520, is spaced apart from the protective tape 400 by a predetermined distance, is located at a sealed portion 130 at which the upper case 120 and the lower case 110, which constitute the pouch case 100, are thermally fused, and fixes the electrode lead 300 to the pouch case 100. Consequently, sealing of the pouch case 100 is maintained while electricity generated by the electrode assembly 200 is prevented from flowing to the pouch case 100 via the electrode lead 300.

It is preferable for the lead film 500 to be made of a non-conductive material that does not conduct electricity well, and an insulating tape that is easily attached to the electrode lead 300 and has a relatively small thickness is generally used; however, the present invention is not limited thereto.

Specifically, the lead film 500 may be made of at least one material selected from the group consisting of polyimide (PI), polypropylene (PP), polyethylene (PE), polyethylene terephthalate (PET), polyvinyl chloride (PVC), high density polyethylene (HDPE), and an epoxy resin. The lead film is bonded to the inner resin layer of the pouch case by thermal fusion using heat and pressure.

Next, the auxiliary terminal 600 will be described. The auxiliary terminal 600 according to the present invention is located at the sealed portion 130 formed at edges of the lower case 110 and the upper case 120 that overlap each other by thermal fusion. Specifically, the auxiliary terminal 600 is located in a longitudinal direction (X-axis direction) of a wing portion 131 of the sealed portion 130, from which the positive electrode lead 310 and the negative electrode lead 320 do not protrude, and is shaped so as to enclose a side end thereof.

Insulation resistance and insulation voltage between the metal layer of the pouch and the cell terminal, i.e., insulation resistance and insulation voltage of the battery cell, are measured through the auxiliary terminal 600, and the wing portion of the sealed portion is maintained pressed by the auxiliary terminal, whereby it is possible to prevent degradation of the adhesion ability of the inner covering layers.

More specifically, the auxiliary terminal 600 is made of a flat metal material that is capable of being bent and being maintained in a deformed shape or an adhesive film containing a conductive material. The auxiliary terminal is located along the edge of the wing portion 131 so as to contact the first metal layer 112 or the second metal layer 122 and to maintain the adhesive ability of the inner covering layer.

Consequently, when the metal layer is exposed due to cracks or the like in the pouch case 100 and short circuit occurs due to contact between the exposed metal layer and an electrolyte in the case or the electrode, it is possible to detect a change in insulation resistance or insulation voltage through a measurement member connected to the auxiliary terminal 600.

Here, the material for the auxiliary terminal 600 is not particularly restricted as long as the material is a metal that is in contact with the metal layer to provide an electrical path and is capable of maintaining the wing portion of the sealed portion pressed. As an example, aluminum or copper may be used. In the case of the adhesive film containing the conductive material, there is no particular restriction as long as the conductive material is included, whereby it is possible to provide an electrical path.

Meanwhile, as shown in FIG. 3, the auxiliary terminal 600 is mounted after the edges of the lower case 110 and upper case 120 are thermally fused, and is widened enough to receive the wing portion 131 of the sealed portion before being mounted. Of course, after the auxiliary terminal 600 is brought into tight contact with a side surface of the wing portion 131, the entirety of the outside of the auxiliary terminal 600 is pressed so as to be fixed.

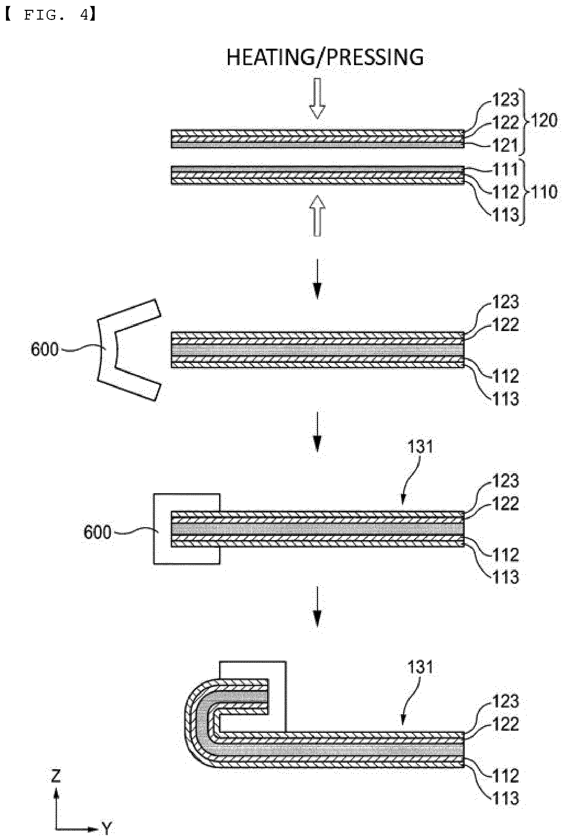

FIG. 4 is a view illustrating a process of mounting an auxiliary terminal according to a preferred second embodiment of the present invention.

A battery cell according to a second embodiment is identical to the battery cell according to the first embodiment described with reference to FIGs. 1 to 3, except for the shape of a sealed portion, and therefore a description of the same configuration will be omitted.

In the second embodiment, in the state in which the auxiliary terminal 600 is fixed to the sealed portion, more specifically a wing portion 131, an edge of the wing portion 131 is folded about 180° together with the auxiliary terminal 600. As a result, the auxiliary terminal 600 and the wing portion 131 may be securely fixed to each other in tight contact with each other.

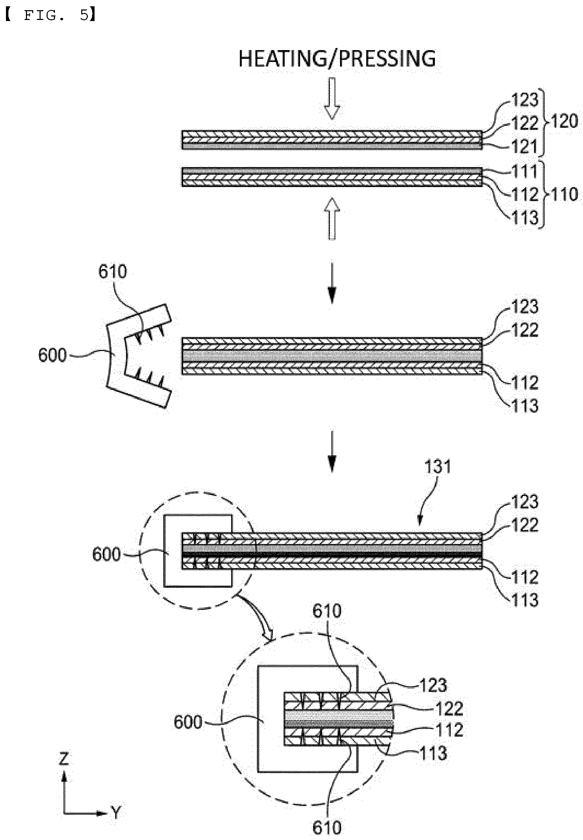

FIG. 5 is a view illustrating a process of mounting an auxiliary terminal according to a preferred third embodiment of the present invention.

A battery cell according to a third embodiment is identical to the battery cell according to the first embodiment described with reference to FIGs. 1 to 3, except for the shape of the auxiliary terminal, and therefore a description of the same configuration will be omitted.

In the third embodiment, the auxiliary terminal 600 is provided at an inner surface thereof, i.e., the surface that faces a first outer resin layer 113 and a second outer resin layer 123 when the auxiliary terminal 600 is mounted to a wing portion 131 of a sealed portion, with a wedge-shaped protrusion 610 made of a metal. When the wedge-shaped protrusion 610 is provided, the auxiliary terminal 600 may be more securely fixed to the wing portion 131.

In addition, it is preferable for the wedge-shaped protrusion 610 located under the first outer resin layer 113 to come into contact with the first metal layer 112 after penetrating the first outer resin layer 113 or for the wedge-shaped protrusion 610 located above the second outer resin layer 123 to come into contact with the second metal layer 122 after penetrating the second outer resin layer 123.

Of course, it is more preferable for the wedge-shaped protrusion 610 under the first outer resin layer 113 to come into contact with the first metal layer 112 and for the wedge-shaped protrusion 610 located above the second outer resin layer 123 to come into contact with the second metal layer 122.

When the wedge-shaped protrusion 610 comes into contact with at least one of the first metal layer 112 and the second metal layer 122, as described above, the function of the auxiliary terminal that provides an electrical path to the metal layer may be reliably secured.

Meanwhile, it is obvious that, in the third embodiment, an edge of the wing portion 131 may be folded about 180° together with the auxiliary terminal 600 in the state in which the auxiliary terminal 600 is fixed to the wing portion 131, as in the second embodiment.

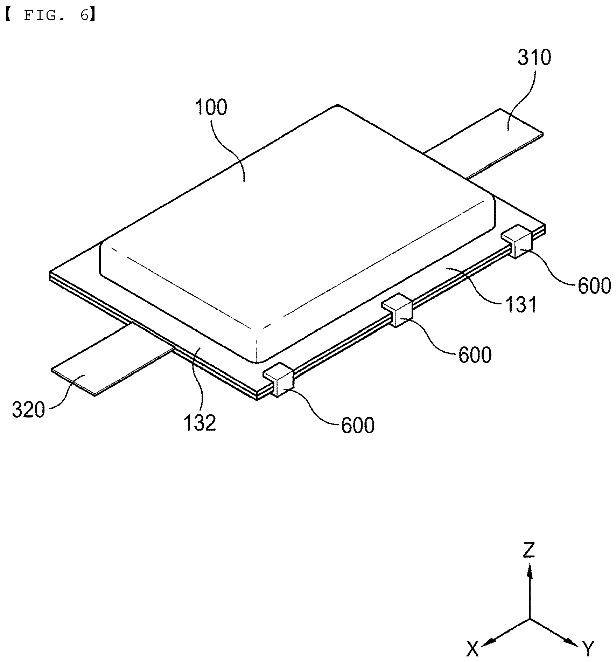

FIG. 6 is a perspective view of a pouch-shaped battery cell according to another example that is not part of the invention.

The battery cell according to the fourth embodiment is identical to the battery cell according to the first embodiment described with reference to FIGs. 1 to 3, except for the length and mounting position of an auxiliary terminal, and therefore a description of the same configuration will be omitted.

In the fourth embodiment, the auxiliary terminals 600 may be mounted to only a part of a wing portion 131 of a sealed portion and may be provided in plurality in a state of being spaced apart from each other by a predetermined distance. At this time, it is obvious that the auxiliary terminal 600 may be provided at an inner surface thereof with a wedge-shaped protrusion as in the third embodiment.

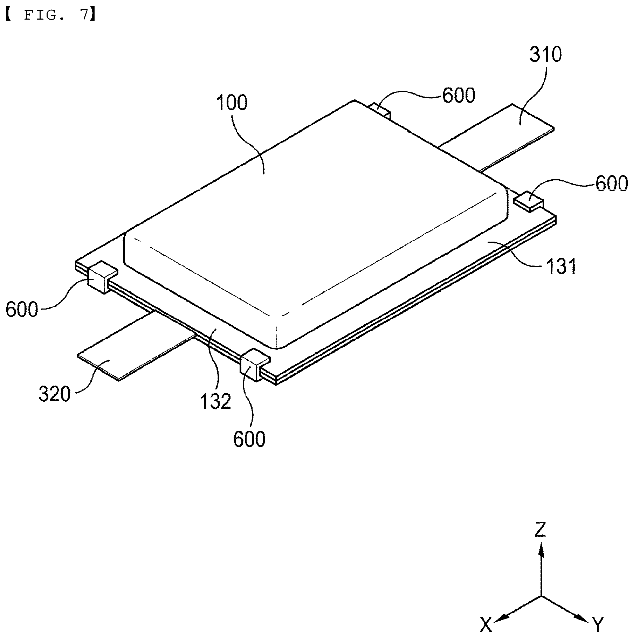

FIG. 7 is a perspective view of a pouch-shaped battery cell according to an embodiment of the present invention.

The battery cell according to the fifth embodiment is identical to the battery cell according to the first embodiment described with reference to FIGs. 1 to 3, except for the length and mounting position of an auxiliary terminal, and therefore a description of the same configuration will be omitted.

In the fifth embodiment, at least one auxiliary terminal 600 may be mounted to a terrace portion 132 from which a positive electrode lead 310 and a negative electrode lead 320 protrude, at which it is more difficult to secure sealing force than at a wing portion 131, and therefore it is possible to prevent deterioration of adhesive performance of internal covering layers located at the terrace portion 132.

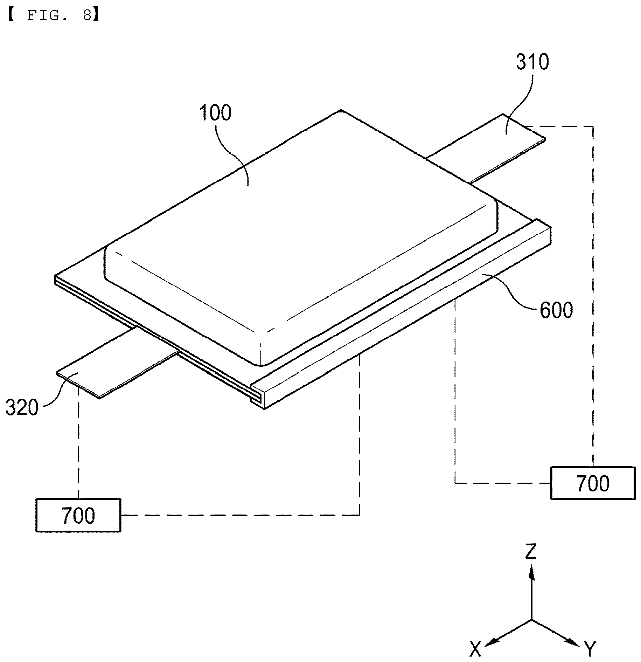

FIG. 8 is a schematic view showing a battery module according to another example that is not part of the invention. A battery module provided with an auxiliary terminal will be described with reference to FIG. 8.

In the battery module according this example, the pouch-shaped battery cell according to the first embodiment is further provided with a measurement member 700. Of course, it is obvious that the measurement member may be connected to the battery cell according to each of the second to fifth embodiments.

As described above, the auxiliary terminal 600 is in contact with the metal layer of the pouch case 100 to provide an electrical path, and the auxiliary terminal 600 may be connected to the measurement member 700, such as a battery management system (BMS), to detect change in insulation resistance or insulation voltage, whereby it is possible to diagnose the state of the battery cell.

Specifically, the measurement member 700 may be connected to the auxiliary terminal 600 and any one of the positive electrode lead 310 and the negative electrode lead 320 to diagnose the state of the battery cell.

As an example, when the measurement member 700 is connected to the auxiliary terminal 600 and the positive electrode lead 310, it is possible to check information about insulation voltage and insulation resistance between the metal layer of the pouch case and the positive electrode, and when the measurement member 700 is connected to the auxiliary terminal 600 and the negative electrode lead 320, it is possible to check information about insulation voltage and insulation resistance between the metal layer of the pouch case and the negative electrode.

Although two measurement members 700 are shown as being respectively connected to the positive electrode lead 310 and the negative electrode lead 320 in FIG. 8, both the positive electrode lead 310 and the negative electrode lead 320 may be connected to one measurement member 700.

The present invention may provide a battery pack including the battery module as described above.

### (Description of Reference Numerals)

100: Pouch case
110: Lower case
111: First inner resin layer 112: First metal layer
113: First outer resin layer
120: Upper case
121: Second inner resin layer 122: Second metal layer
123: Second outer resin layer
130: Sealed portion
131: Wing portion 132: Terrace portion
200: Electrode assembly
210: Positive electrode tab 220: Negative electrode tab
300: Electrode lead
310: Positive electrode lead 320: Negative electrode lead
400: Protective tape
410: First protective tape 420: Second protective tape
500: Lead film
510: First lead film 520: Second lead film
600: Auxiliary terminal
700: Measurement member

## Claims

1. A pouch-shaped battery cell comprising:
a pouch case (100) constituted by a lower case (110) including a first inner resin layer (111), a first metal layer (112), and a first outer resin layer (113) that are sequentially stacked and an upper case (120) including a second inner resin layer (121), a second metal layer (122), and a second outer resin layer (123) that are sequentially stacked;
an electrode assembly (200) located in the pouch case (100), the electrode assembly (200) comprising a positive electrode, a negative electrode, and a separator, the electrode assembly (200) having a pair of electrode tabs (210, 220) formed at one side or opposite sides thereof; and
a pair of electrode leads (300) connected to the pair of electrode tabs (210, 220), the pair of electrode leads (300) protruding outwards from the pouch case (100), wherein
a thermally fused sealed portion (130) is formed at edges of the lower case (110) and the upper case (120) that face each other,
an auxiliary terminal (600) is in contact with the first metal layer (112) or the second metal layer (122) so as to enclose a side end of the sealed portion (130), and
wherein the sealed portion (130) comprises a wing portion (131) from which no electrode lead (300) protrudes and a terrace portion (132) from which the electrode lead (300) protrudes,
**characterized in that** the auxiliary terminal (600) is provided at the terrace portion (132),
wherein the auxiliary terminal (600) is made of a flat metal material that is capable of being bent or an adhesive film containing a conductive material,
wherein the terrace portion (132) is maintained pressed by the auxiliary terminal (600).

2. The pouch-shaped battery cell according to claim 1, wherein the auxiliary terminal (600) is provided at an inner surface thereof with a wedge-shaped protrusion (610).

3. The pouch-shaped battery cell according to claim 2, wherein the wedge-shaped protrusion (610) comes into contact with the first metal layer (112) after penetrating the first outer resin layer (113) or comes into contact with the second metal layer (122) after penetrating the second outer resin layer (123).

4. A battery module comprising:
the pouch-shaped battery cell according to any one of claims 1 to 3; and
a measurement member (700) having one side connected to the auxiliary terminal (600) and the other side connected to the positive electrode lead (310) or the negative electrode lead (320).

5. The battery module according to claim 4, wherein the measurement member (700) is provided in two, one of which is connected to the auxiliary terminal (600) and the positive electrode lead (310) and the other of which is connected to the auxiliary terminal (600) and the negative electrode lead (320).

6. The battery module according to claim 4, wherein the measurement member (700) is a battery management system (BMS).

7. A battery pack comprising the battery module according to claim 4.

## Patentansprüche

1. Beutelartige Batteriezelle, umfassend:
ein Beutelgehäuse (100), das aus einem unteren Gehäuse (110), das eine erste innere Harzschicht (111), eine erste Metallschicht (112) und eine erste äußere Harzschicht (113) enthält, die sequentiell gestapelt sind, und einem oberen Gehäuse (120), das eine zweite innere Harzschicht (121), eine zweite Metallschicht (122) und eine zweite äußere Harzschicht (123) enthält, die sequentiell gestapelt sind, gebildet ist;
eine Elektrodenanordnung (200), die sich in dem Beutelgehäuse (100) befindet, wobei die Elektrodenanordnung (200) eine positive Elektrode, eine negative Elektrode und einen Separator umfasst, wobei die Elektrodenanordnung (200) ein Paar Elektrodenfahnen (210, 220) aufweist, die an einer Seite oder an gegenüberliegenden Seiten davon ausgebildet sind;
und
ein Paar Elektrodenableiter (300), die mit dem Paar Elektrodenfahnen (210, 220) verbunden sind, wobei das Paar Elektrodenableiter (300) von dem Beutelgehäuse (100) nach außen vorsteht, wobei
ein thermisch verschmolzener versiegelter Abschnitt (130) an Kanten des unteren Gehäuses (110) und des oberen Gehäuses (120) ausgebildet ist, die einander zugewandt sind,
ein Hilfsanschluss (600) mit der ersten Metallschicht (112) oder der zweiten Metallschicht (122) in Kontakt steht, um ein Seitenende des versiegelten Abschnitts (130) zu umschließen, und
wobei der versiegelte Abschnitt (130) einen Flügelabschnitt (131), von dem kein Elektrodenableiter (300) vorsteht, und einen Terrassenabschnitt (132), von dem der Elektrodenableiter (300) vorsteht, umfasst,
**dadurch gekennzeichnet, dass** der Hilfsanschluss (600) an dem Terrassenabschnitt (132) vorgesehen ist,
wobei der Hilfsanschluss (600) aus einem flachen Metallmaterial, das gebogen werden kann, oder einer Klebefolie, die ein leitfähiges Material enthält, hergestellt ist,
wobei der Terrassenabschnitt (132) durch den Hilfsanschluss (600) gedrückt gehalten wird.

2. Beutelartige Batteriezelle nach Anspruch 1, wobei der Hilfsanschluss (600) an einer Innenfläche davon mit einem keilförmigen Vorsprung (610) versehen ist.

3. Beutelartige Batteriezelle nach Anspruch 2, wobei der keilförmige Vorsprung (610) nach dem Durchdringen der ersten äußeren Harzschicht (113) mit der ersten Metallschicht (112) in Kontakt kommt oder nach dem Durchdringen der zweiten äußeren Harzschicht (123) mit der zweiten Metallschicht (122) in Kontakt kommt.

4. Batteriemodul, umfassend:
die beutelartige Batteriezelle nach einem der Ansprüche 1 bis 3; und
ein Messelement (700), dessen eine Seite mit dem Hilfsanschluss (600) verbunden ist und dessen andere Seite mit dem positiven Elektrodenableiter (310) oder dem negativen Elektrodenableiter (320) verbunden ist.

5. Batteriemodul nach Anspruch 4, wobei das Messelement (700) in zweifacher Ausführung vorgesehen ist, von denen eines mit dem Hilfsanschluss (600) und dem positiven Elektrodenableiter (310) verbunden ist und das andere mit dem Hilfsanschluss (600) und dem negativen Elektrodenableiter (320) verbunden ist.

6. Batteriemodul nach Anspruch 4, wobei das Messelement (700) ein Batteriemanagementsystem (BMS) ist.

7. Batteriepack, umfassend das Batteriemodul nach Anspruch 4.

## Revendications

1. Élément de batterie de type poche comprenant :
un boîtier de poche (100) constitué par un boîtier inférieur (110) incluant une première couche de résine intérieure (111), une première couche métallique (112), et une première couche de résine extérieure (113) qui sont empilées séquentiellement et un boîtier supérieur (120) incluant une deuxième couche de résine intérieure (121), une deuxième couche métallique (122), et une deuxième couche de résine extérieure (123) qui sont empilées séquentiellement ;
un ensemble d'électrodes (200) situé dans le boîtier de poche (100), l'ensemble d'électrodes (200) comprenant une électrode positive, une électrode négative, et un séparateur, l'ensemble d'électrodes (200) ayant une paire d'onglets d'électrode (210, 220) formés sur un côté ou des côtés opposés de celui-ci ;
et
une paire de languettes d'électrode (300) connectées à la paire d'onglets d'électrode (210, 220), la paire de languettes d'électrode (300) faisant saillie vers l'extérieur depuis le boîtier de poche (100), dans lequel
une partie scellée thermoscellée (130) est formée aux bords du boîtier inférieur (110) et du boîtier supérieur (120) qui se font face,
une borne auxiliaire (600) est en contact avec la première couche métallique (112) ou la deuxième couche métallique (122) de manière à enserrer une extrémité latérale de la partie scellée (130), et
dans lequel la partie scellée (130) comprend une partie d'aile (131) de laquelle aucune languette d'électrode (300) ne fait saillie et une partie en terrasse (132) de laquelle la languette d'électrode (300) fait saillie,
**caractérisé en ce que** la borne auxiliaire (600) est prévue au niveau de la partie en terrasse (132),
dans lequel la borne auxiliaire (600) est faite d'un matériau métallique plat qui est apte à être plié ou d'un film adhésif contenant un matériau conducteur,
dans lequel la partie en terrasse (132) est maintenue pressée par la borne auxiliaire (600).

2. L'élément de batterie de type poche selon la revendication 1, dans lequel la borne auxiliaire (600) est pourvue, sur une surface intérieure de celle-ci, d'une saillie en forme de coin (610).

3. L'élément de batterie de type poche selon la revendication 2, dans lequel la saillie en forme de coin (610) vient en contact avec la première couche métallique (112) après avoir pénétré la première couche de résine extérieure (113) ou vient en contact avec la deuxième couche métallique (122) après avoir pénétré la deuxième couche de résine extérieure (123).

4. Module de batterie comprenant :
l'élément de batterie de type poche selon l'une quelconque des revendications 1 à 3 ; et
un élément de mesure (700) ayant un côté connecté à la borne auxiliaire (600) et l'autre côté connecté au terminal d'électrode positif (310) ou au terminal d'électrode négatif (320).

5. Le module de batterie selon la revendication 4, dans lequel l'élément de mesure (700) est prévu en deux exemplaires, dont l'un est connecté à la borne auxiliaire (600) et au languette d'électrode positive (310) et dont l'autre est connecté à la borne auxiliaire (600) et au languette d'électrode négative (320).

6. Le module de batterie selon la revendication 4, dans lequel l'élément de mesure (700) est un système de gestion de batterie (BMS).

7. Bloc-batterie comprenant le module de batterie selon la revendication 4.
